# EUROPEAN PATENT APPLICATION

(11) **EP 4 583 664 A1**
(43) Date of publication of application: **09.07.2025**
(21) Application number: 24181555.4
(22) Date of filing: 12.06.2024
(51) Int. Cl.: H10D 62/10, H10D 89/60, H10D 8/80, H10D 8/01

(54) **TRANSISTOR TRIGGERED SILICON CONTROL RECTIFIER**

(30) Priority: 03.01.2024 US 202418403206
(71) Applicant: GlobalFoundries U.S. Inc., Malta, NY 12020 (US)
(72) Inventor: KARALKAR, Sagar Premnath, 738406 Singapore (SG); LOISEAU, Alain F., Essex Junction, VT 05452 (US); MIAO, Meng, Williston, VT 05495 (US); NATH, Anindya, Essex Junction, VT 05452 (US); LIANG, Wei, Essex Junction, VT 05452 (US); MITRA, Souvick, Essex Junction, VT 05452 (US); KRISHNASAMY, Rajendran, Essex Junction, VT 05452 (US)
(74) Representative: Lambacher, Michael

(57) **Abstract**

The present disclosure relates to semiconductor structures and, more particularly, to a transistor triggered silicon control rectifier (SCR) and methods of manufacture. The structure includes: a vertical silicon controlled rectifier; and a triggering device adjacent to the vertical silicon controlled rectifier, the triggering device and the vertical silicon controlled rectifier sharing a diffusion region within a semiconductor substrate.

## Description

### BACKGROUND

The present disclosure relates to semiconductor structures and, more particularly, to a transistor triggered silicon control rectifier (SCR) and methods of manufacture.

SCRs are used for electrostatic discharge (ESD) protection of integrated circuits (ICs) from the sudden flow of electricity caused by, for example, contact, electrical shorts, or dielectric breakdown. Because of high current handling ability per unit area of an SCR, ESD devices utilizing SCR can protect ICs from failure. These devices are most often used in high performance analog and radiofrequency (RF) designs for chips that have large signal swings, low leakage, and low capacitance. Due to the capacitance loading and poor harmonics of SCRs, RF performance may be impacted.

### SUMMARY

In an aspect of the disclosure, a structure comprises: a vertical silicon controlled rectifier; and a triggering device adjacent to the vertical silicon controlled rectifier, the triggering device and the vertical silicon controlled rectifier sharing a diffusion region within a semiconductor substrate.
Additional features of the structure are set forth in dependent claims 2 to 10.

In an aspect of the disclosure, a structure comprises: a vertical silicon controlled rectifier comprising a diffusion region in a semiconductor substrate of a first dopant type; a lateral triggering device sharing the diffusion region with the vertical silicon controlled rectifier, the diffusion region being a source region for the lateral triggering device; and a body contact of a second dopant type connecting to ground and tied to the semiconductor substrate.
Additional features of the structure are set forth in dependent claims 12 to 14.

In an aspect of the disclosure, a method comprises: forming a vertical silicon controlled rectifier; and forming a triggering device adjacent to the vertical silicon controlled rectifier, the triggering device and the vertical silicon controlled rectifier sharing a diffusion region within a semiconductor substrate.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a transistor triggered silicon control rectifier (SCR) and respective fabrication processes in accordance with aspects of the present disclosure.
FIG. 2 shows a transistor triggered SCR and respective fabrication processes in accordance with additional aspects of the present disclosure.
FIG. 3 shows a top view of the transistor of FIG. 1 across line A-A in accordance with aspects of the present disclosure.
FIG. 4 shows a top view of the transistor of FIG. 1 across line A-A in accordance with additional aspects of the present disclosure.
FIGS. 5A-5D show cross-sectional views of steps in the fabrication processes of the transistor triggered SCR of FIG. 1 in accordance with further aspects of the present disclosure.

### DETAILED DESCRIPTION

The present disclosure relates to semiconductor structures and, more particularly, to a transistor triggered silicon control rectifier (SCR) and methods of manufacture. In embodiments, the transistor triggered SCR may be a vertical bipolar transistor with a lateral triggering transistor. The triggering transistor may be a NMOS or PMOS and the SCR may be a PNPN or NPNP. Advantageously, the structures described herein exhibit lowered trigger voltage and faster switching times.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

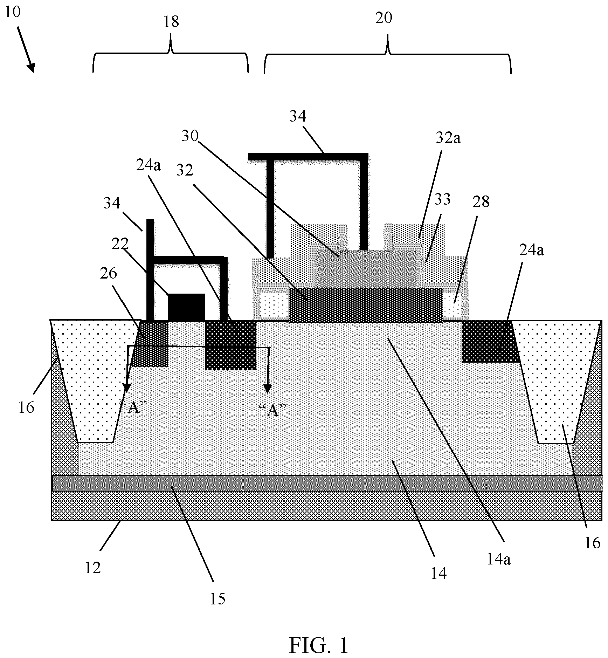

FIG. 1 shows a transistor triggered silicon control rectifier (SCR) and respective fabrication processes in accordance with aspects of the present disclosure. The structure 10 of FIG. 1 includes a transistor 18 and SCR 20 over p-well 14 in a semiconductor substrate 12. The p-well 14 may be formed by a conventional ion implantation process with p-type dopants, e.g., Boron (B), as is known in the art such that no further explanation is required for a complete understanding of the present disclosure. The p-well 14 may be provided within or bounded by a deep n-well 15 used to isolate the p-well 14. Deep trench isolation structures 16 may also be used to isolate the p-well 14, e.g., isolate the transistor 18 and the SCR 20.

The semiconductor substrate 12 may be composed of any suitable semiconductor material including, but not limited to, Si, SiGe, SiGeC, SiC, GaAs, InAs, InP, and other III/V or II/VI compound semiconductors. The semiconductor substrate 12 may also comprise any suitable single crystallographic orientation (e.g., a (100), (110), (111), or (001) crystallographic orientation). In further embodiments, the semiconductor substrate 12 may be a bulk substrate comprising the semiconductor materials described herein or, alternatively, may comprise semiconductor on insulator technology as is known in the art. In the semiconductor on insulator technology, the semiconductor substrate 12 would be a top semiconductor layer over an insulator material and a handle substrate as is known in the art.

In embodiments, the structure 10 includes a transistor 18 and an SCR 20. The transistor 18 may be a lateral NMOS transistor; whereas the SCR 20 may be a vertical PNPN SCR. In embodiments, the transistor 18 may be a triggering device for the SCR 20.

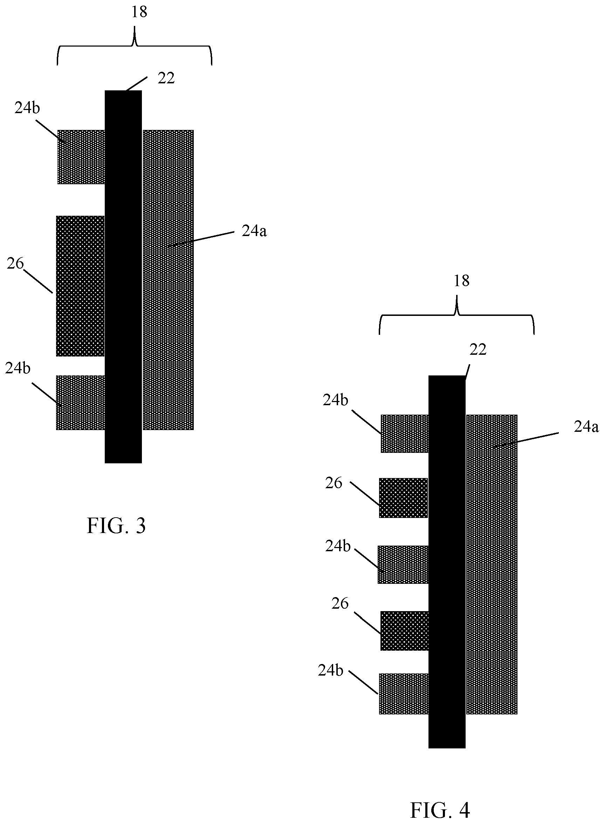

The transistor 18 includes a gate structure 22 with a N+ diffusion region 24a (N+ source region) and N+ diffusion region 24b (N+ drain region) shown in more detail with respect to FIGS. 3 and 4. The gate structure 22 may be any conventional gate structure, e.g., polysilicon gate structure or, alternatively, a metal gate structure. In the polysilicon configuration, the gate structure 22 may have a partially or fully silicide region on a top surface. The gate structure 22 may be grounded or placed at a different bias. The N+ diffusion regions 24a, 24b (N+ source region and N+ drain region) may be provided within the p-well 14, e.g., tied directly to the p-well 14. The N+ diffusion regions 24a, 24b may include a fully or partially silicide region on a top surface.

The vertical SCR 20 includes a P+ emitter 30, N+ base region 32 and the N+ diffusion region 24a. As noted herein, the N+ diffusion region 24a is shared with the transistor 18 and the SCR 20. In addition, the SCR 20 includes a p+ collector region 14a in the p-well 14, between the base region 32 and the N+ diffusion region 24a. In this way, the SCR 20 is a PNPN device.

The N+ base region 32 may be laterally isolated from the N+ diffusion region 24a by sidewall spacers 28. In embodiments, the sidewall spacers 28 may be an oxide material, nitride material or combinations thereof. The base region 32 may include an extrinsic base region 32a (e.g., N+ tap region) in direct contact with the base region 32. The N+ tap region 32a may be isolated from the P+ emitter 30 by insulator material 33. Also, the base region 32a and the P+ body contact 26 may include a fully or partially silicide region on a top surface.

The P+ emitter 30 may comprise polysilicon material and the base region 32 may comprise, e.g., n-doped SiGe. The n-doped SiGe may be epitaxially grown on the semiconductor substrate 12, with an in-situ doping. In embodiments, the in-situ doping may be n-type dopants, e.g., Arsenic (As), Phosphorus (P) and Antimony (Sb), among other suitable examples.

A P+ body contact 26 may be provided in the p-well 14, adjacent to the gate structure 22. The P+ body contact 26 may include a fully or partially silicide region on a top surface. In embodiments, the P+ body contact 26 is tied to ground (GND); that is, the P+ body contact 26 is not floating.

The extrinsic base region 32a, P+ emitter 30, N+ diffusion region 24a and P+ body contact 26 are connected to wiring structures 34. In embodiments, the P+ body contact 26 is connected to ground (GND). In further embodiments, the N+ diffusion region 24a is connected to the cathode and the P+ emitter 30 is connected to the anode. In embodiments, the gate structure 22 may also be tied to the anode of the device.

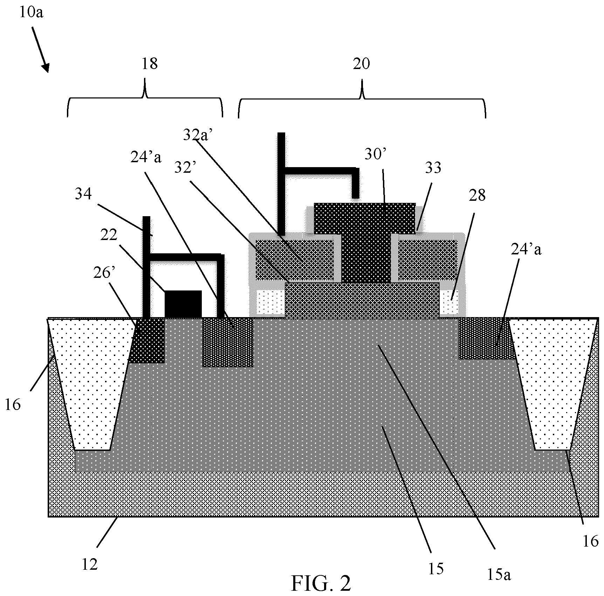

FIG. 2 shows a transistor triggered SCR in accordance with additional aspects of the present disclosure. The structure 10a of FIG. 2 includes a lateral PMOS transistor and a vertical NPNP SCR.

In embodiments, the structure 10a includes an n-well 15 in the semiconductor substrate 12. The n-well 15 may be formed by a conventional ion implantation process with n-type dopants, e.g., Arsenic (As), Phosphorus (P) and Antimony (Sb), among other suitable examples as is known in the art. The deep trench isolation structures 16 may be used to isolate the n-well 15, e.g., the transistor 18 and the SCR 20. The semiconductor substrate 12 may be composed of any suitable semiconductor material with any suitable single crystallographic orientation as already disclosed herein. In further embodiments, the semiconductor substrate 12 may be a bulk substrate or, alternatively, may comprise semiconductor on insulator technology as is known in the art.

Still referring to FIG. 2, the transistor 18 may be a triggering device for the SCR 20. The transistor 18 includes the gate structure 22 with a P+ diffusion region 24'a and P+ diffusion region (not shown in this view). The gate structure 22 may be any conventional gate structure, e.g., polysilicon gate structure or, alternatively, a metal gate structure. In the polysilicon configuration, the gate structure 22 may have a partially or fully silicide region on a top surface. The gate structure 22 may be grounded or placed at a different bias. The P+ diffusion regions 24a (e.g., P+ source and drain regions) may be provided within the n-well 15.

The vertical SCR 20 includes an N+ emitter 30', P+ base region 32', a collector region 15a in the n-well 15, and the P+ diffusion region 24'a. In this way, the SCR 20 is an NPNP device. As noted herein, the P+ diffusion region 24'a is shared with the transistor 18 and the SCR 20.

The P+ base region 32' may be laterally isolated from the P+ diffusion region 24'a by sidewall spacers 28, e.g., oxide material, nitride material or combinations thereof. The base region 32' may include an extrinsic base region 32'a (e.g., P+ tap region) in direct contact with the base region 32'. The N+ emitter 30' may comprise polysilicon material and the base region 32' may comprise, e.g., p-doped SiGe epitaxially grown on the semiconductor substrate 12 with an in-situ doping, e.g., p-type dopants. An N+ body contact 26' is tied to the n-well 15, adjacent to the gate structure 22.

The extrinsic base region 32'a, N+ emitter 30', P+ diffusion region 24'a and N+ body contact 26' are connected to wiring structures 34. In embodiments, the N+ body contact 26 is connected to ground (GND). In further embodiments, the P+ diffusion region 24'a is connected to the anode and the N+ emitter 30' and base region 32' are connected to the cathode.

FIGS. 3 and 4 show different top views of different configurations of the transistor 18 of FIG. 1 along line A-A. It should be recognized by those of skill in the art that the top views shown in FIGS. 3 and 4 may equally represent the structure 10a of FIG. 2 by simply changing the dopant type of the diffusion region 24a, drain region 24b and the body contact 26.

In FIG. 3 the transistor 18 includes a single diffusion region 24a (source region) on one side of the gate structure 22 and multiple diffusion regions (drain regions) 24b on an opposing side of the gate structure 22. In this embodiment, the drain regions 24b comprise two tabs located at opposing ends of the P+ body contact 26. FIG. 4, on the other hand, shows alternating tabs comprising the drain regions 24b interdigitated with the P+ body contacts 26.

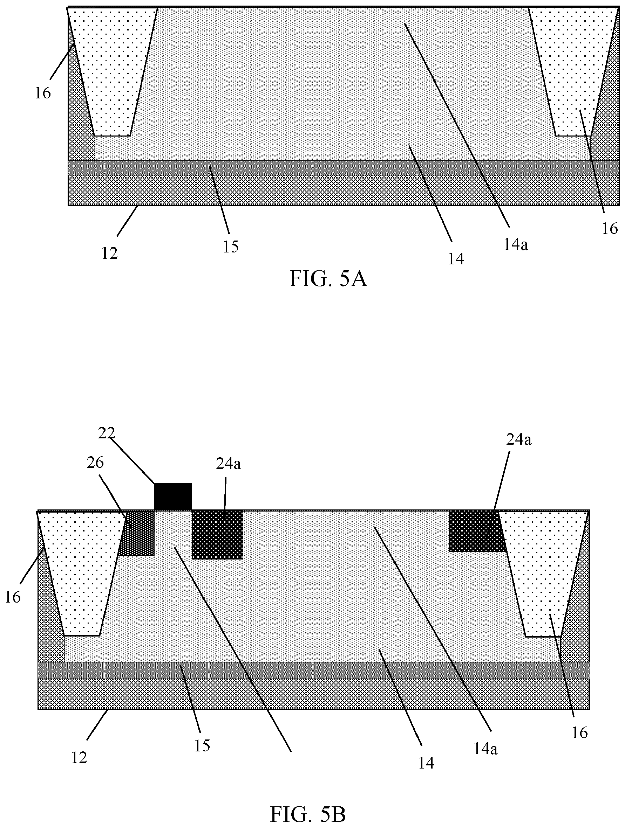

FIG. 5A-5D show cross-sectional views of steps in the fabrication processes of the transistor triggered SCR of FIG. 1. It should be recognized by those of skill in the art that the fabrication processes shown in FIGS. 5A-5D may equally represent fabrication processes of the transistor triggered SCR of FIG. 2 by changing dopant types.

As shown in FIG. 5A, for example, a p-well 14 is provided with the semiconductor substrate 12 using a conventional ion implantation process as is known in the art. Deep trench isolation structures 16 are formed in the semiconductor substrate 12, surrounding the p-well 14.

The deep trench isolation structures 16 may be formed by conventional lithography, etching and deposition processes. For example, a resist formed over the semiconductor substrate 12 is exposed to energy (light) and developed utilizing a conventional resist developer to form a pattern (opening). An etching process with a selective chemistry, e.g., reactive ion etching (RIE), will be used to transfer the pattern from the photoresist layer to the semiconductor substrate 12 to form one or more trenches in the semiconductor substrate 12 through the openings of the resist. Following the resist removal by a conventional oxygen ashing process or other known stripants, insulator material (e.g., SiO₂) can be deposited by any conventional deposition processes, e.g., CVD processes. Any residual material on the surface of the semiconductor substrate 12 can be removed by conventional chemical mechanical polishing (CMP) processes.

FIG. 5B shows the formation of the source region 24a and the body contact 26. It should be understood by those of skill in the art that the drain region 24b may also be formed at the same time as the source region 24a. The source region 24a, drain region 24b and the body contact 26 may be formed by introducing a concentration of a different dopant of opposite conductivity type in the semiconductor substrate 12.

In embodiments, respective patterned implantation masks may be used to define selected areas exposed for the implantations. The implantation mask used to select the exposed area for forming source region 24a and drain region 24b is stripped after implantation, and before the implantation mask used to form the body contact 26 (or vice versa). Similarly, the implantation mask used to select the exposed area for forming body contact 26 is stripped after the implantation is performed. The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The body contact 26 is doped with p-type dopants, e.g., Boron (B), and the source region 24a (and drain region 24b) is doped with n-type dopants, e.g., Arsenic (As), Phosphorus (P) and Sb, among other suitable examples. It should be recognized that opposite dopant types may be used to form the structure 10a of FIG. 2.

Still referring to FIG. 5B, the gate structure 22 may be formed by conventional gate fabrication processes. For example, a gate dielectric material (e.g., high-k dielectric material or low-k dielectric material) may be deposited on the semiconductor substrate 12, followed by a deposition of polysilicon material. The gate dielectric material may be formed by conventional atomic layer deposition (ALD) or CVD processes including plasma enhanced CVD (PECVD) processes. The polysilicon material may be deposited by a CVD process. Following the deposition processes, the gate dielectric material and polysilicon material are patterned using conventional lithography and etching processes as is known in the art. The gate structures 22 may also include sidewall spacers comprising oxide, nitride or combinations thereof. The sidewall spacers may be fabricated using conventional deposition processes, e.g., CVD, followed by an anisotropic etching process.

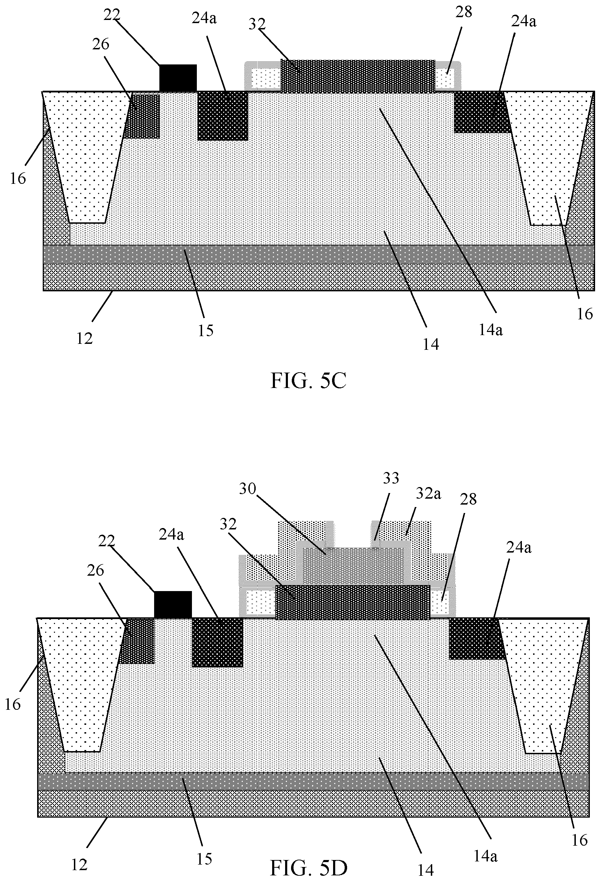

FIG. 5C shows the fabrication of the base region 32 and sidewall spacers 28. The base region 32 may be fabricated by a conventional epitaxial growth process with an in-situ doping. In the structure of FIG. 1, the doping would be an n-type dopant; whereas in the structure of FIG. 2, the doping would be a p-type dopant. Following a conventional patterning process, e.g., lithography and etching, the sidewall spacers 28 may be formed by a conventional deposition and an anisotropic etching process as already disclosed herein.

FIG. 5D shows the fabrication of the emitter region 30 and the tap region 32a (e.g., extrinsic base). The emitter region 30 may be fabricated by a conventional epitaxial growth process with an in-situ doping. In the structure of FIG. 1, the doping would be a p-type dopant; whereas in the structure of FIG. 2, the doping would be an n-type dopant. Following a conventional deposition process for forming sidewall spacers (insulator material) 33 and a patterning process to expose portions of the base region 32, the emitter region 30 may be epitaxially grown, in contact with the base region 32.

Referring back to FIG. 1, wiring structures 34 are formed using conventional lithography, etching and deposition processes. For example, an interlevel dielectric material may be deposited by a conventional deposition method, e.g., CVD. The interlevel dielectric material may be deposited by conventional lithography and etching processes to form trenches exposing the extrinsic base region 32a, P+ emitter 30, N+ source region 24a and P+ body contact 26. A conductive material is deposited into the trenches to form the wiring structures 34. The conductive material may be aluminum, copper, tungsten or other known materials. To prevent out-diffusion, the sidewalls of the trenches may be lined with TaN or TiN as is known in the art.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a vertical silicon controlled rectifier; and
a triggering device adjacent to the vertical silicon controlled rectifier, the triggering device and the vertical silicon controlled rectifier sharing a diffusion region within a semiconductor substrate.

2. The structure of claim 1, wherein the vertical silicon controlled rectifier comprises a PNPN device and the triggering device comprises an lateral NMOS transistor.

3. The structure of claim 2, wherein the shared diffusion region comprises an N+ source region of the NMOS transistor and an N+ contact of the PNPN device.

4. The structure of claim 3, wherein the PNPN device comprises a P+ emitter, N+ base, P+ collector region and the N+ contact, the N+ contact being shared with the NMOS transistor.

5. The structure of one of claims 2 to 4, wherein the NMOS transistor comprises a gate structure comprising silicided polysilicon, and/or wherein the structure further comprises a P+ body contact connecting to ground and tied to a p-well in the semiconductor substrate.

6. The structure of claim 1, wherein the vertical silicon controlled rectifier comprises an NPNP device and the triggering device comprises an PMOS transistor, and, optionally, wherein the PMOS transistor is a lateral PMOS transistor.

7. The structure of claim 6, wherein the shared diffusion region comprises a P+ source region of the PMOS transistor and a P+ contact of the NPNP device.

8. The structure of claim 7, wherein the NPNP device comprises an N+ emitter, P+ base, N+ collector region and the P+ contact, the P+ contact being shared with the PMOS transistor.

9. The structure of one of claims 6 to 8, wherein the lateral PMOS transistor comprises a gate structure comprising silicided polysilicon, and/or wherein the structure further comprises an N+ body contact connecting to ground and tied to an n-well in the semiconductor substrate.

10. The structure of one of claims 1 to 9, further comprising a body contact of a first dopant type tied to the semiconductor substrate, the body contact being connecting to ground and interdigitated with a drain region of the triggering device, the drain region being of a second dopant type.

11. A structure comprising:
a vertical silicon controlled rectifier comprising a diffusion region in a semiconductor substrate of a first dopant type;
a lateral triggering device sharing the diffusion region with the vertical silicon controlled rectifier, the diffusion region being a source region for the lateral triggering device; and
a body contact of a second dopant type connecting to ground and tied to the semiconductor substrate.

12. The structure of claim 11, wherein the vertical silicon controlled rectifier comprises a PNPN device and the triggering device comprises an NMOS transistor, the diffusion region comprises an N+ diffusion region and the body contact comprising a P+ body contact tied to a p-well in the semiconductor substrate, and, optionally, wherein the PNPN device comprises a P+ emitter, N+ base, P+ collector region and an N+ contact, the N+ contact being shared with the NMOS transistor.

13. The structure of claim 11, wherein the vertical silicon controlled rectifier comprises a NPNP device and the triggering device comprises an PMOS transistor, the diffusion region comprises a P+ diffusion region and the body contact comprising an N+ body contact tied to an n-well in the semiconductor substrate, and, optionally, wherein the NPNP device comprises an N+ emitter, P+ base, N+ collector region and a P+ contact, the P+ contact being shared with the PMOS transistor.

14. The structure of one of claims 11 to 13, further comprising deep trench isolation structures extending into the semiconductor substrate and surrounding a well, the deep trench isolation structures further isolating the vertical silicon controlled rectifier and lateral triggering device.

15. A method comprising:
forming a vertical silicon controlled rectifier; and
forming a triggering device adjacent to the vertical silicon controlled rectifier, the triggering device and the vertical silicon controlled rectifier sharing a diffusion region within a semiconductor substrate.
